# FASCICULE DE BREVET EUROPEEN

(11) **EP 1 570 509 B1**
(45) Date de publication et mention de la délivrance du brevet: **21.01.2009**
(21) Numéro de dépôt: 03796161.2
(22) Date de dépôt: 04.12.2003
(51) Int. Cl.: H01L 21/20, H01L 21/18, H01L 21/762, H01L 21/58

(54) **PROCEDE DE REALISATION D' UNE STRUCTURE COMPLEXE PAR ASSEMBLAGE DE STRUCTURES CONTRAINTES**
HERSTELLUNGSVERFAHREN EINER KOMPLEXEN STRUKTUR DURCH ZUSAMMENFÜGEN VERSPANNTER STRUKTUREN
METHOD OF PRODUCING A COMPLEX STRUCTURE BY ASSEMBLING STRESSED STRUCTURES

(30) Priorité: 09.12.2002 FR 0215552
(43) Date de publication de la demande: 07.09.2005
(73) Titulaire: COMMISSARIAT A L'ENERGIE ATOMIQUE, 75015 Paris (FR)
(72) Inventeur: Fournel, Franck, F-38430 Moirans (FR); Moriceau, Hubert, F-38120 Saint-Egreve (FR); Montmayeul, Philippe, F-38190 Bernin (FR)
(74) Mandataire: Quantin, Bruno Marie Henri
(86) Numéro de dépôt international: PCT/FR2003/003590
(87) Numéro de publication internationale: WO 2004/064132

(56) Documents cités:
- EP-A- 0 383 391
- EP-A- 0 410 679
- EP-A- 0 895 282
- FR-A- 2 789 518
- US-A- 4 832 253
- US-A- 5 131 968
- FEIJOO D ET AL: "Prestressing of bonded wafers" PROCEEDINGS OF THE FIRST INTERNATIONAL SYMPOSIUM ON SEMICONDUCTOR WAFER BONDING: SCIENCE, TECHNOLOGY AND APPLICATIONS, PHOENIX, AZ, USA, 13-18 OCT. 1991, pages 230-238, XP008021005 1992, Pennnington, NJ, USA, Electrochem. Soc, USA cité dans la demande
- PATENT ABSTRACTS OF JAPAN vol. 013, no. 444 (E-828), 5 octobre 1989 (1989-10-05) -& JP 01 169917 A (FUJITSU LTD), 5 juillet 1989 (1989-07-05)

## Description

### Domaine technique

L'invention concerne un procédé de réalisation d'une structure complexe par assemblage de deux structures microélectroniques élémentaires. Ces structures peuvent être microélectroniques, microtechnologiques, monotechnologiques ou encore manoélectroniques.

L'utilisation de ces structures complexes, notamment de celles obtenues par assemblage de structures de matériaux différents, est de plus en plus répandue en microélectronique et ce, pour des raisons très diverses. Ces structures complexes, encore appelées hétérostructures, permettent en effet, par exemple, de réduire les coûts en évitant d'utiliser des substrats massifs chers (c'est le cas du carbure de silicium par exemple). Elles permettent également, dans le cas d'un substrat SOI (silicium sur isolant) par exemple, d'isoler facilement les composants les uns des autres permettant ainsi d'augmenter la densité d'intégration, de limiter la consommation des composants, d'augmenter leur rapidité.

### Etat de la technique antérieure

Le document FR 2789518 décrit une structure multicouche à contraintes internes contrôllées et une procédé de réalisation d'un telle structure. Ces structures complexes, pour être avantageuses, doivent être compatibles moyennant des modifications mineurs avec les étapes technologiques classiques de la microélectronique, collage, traitement thermique, lithographie, dopage, implantation ou encore épitaxie par exemple. Or, la plupart de ces étapes nécessitent des changements de température importants pour leur mise en oeuvre.

Contrairement à un substrat massif qui évolue de façon homogène avec la température, les hétérostructures sont sensibles au changement de température et ce d'autant plus nettement que les matériaux qui la composent présentent des coefficients de dilatation thermique différents. Le changement de température peut engendrer, au sein de l'hétérostructure, des contraintes internes importantes du fait des évolutions différentes des matériaux en température. Ces contraintes peuvent même, si elles sont trop importantes, endommager ou même détruire la structure complexe. La solution pour éviter de tels problèmes est classiquement de se limiter à des changements de température modérés qui soient compatibles avec la structure existante.

Réaliser de façon fiable et reproductible une structure complexe par assemblage de deux matériaux différents de sorte que cette structure puisse, sans risque, subir des étapes technologiques à plus haute température ou de plus longue durée que celles auxquelles on se limite actuellement, reste donc un problème.

Un autre problème important en microélectronique est de pouvoir réaliser une épitaxie de bonne qualité d'un matériau donné sur un autre matériau. La difficulté réside, dans ce cas, dans l'éventuelle différence qui existe entre les paramètres de maille des deux matériaux, celui du substrat et celui à épitaxier. Par exemple, si on veut épitaxier du Si_{0.8}Ge_{0.2} sur du silicium, la différence de maille est tellement importante entre ces deux matériaux qu'il n'est pas possible de faire croître la couche de Si_{0.8}Ge_{0.2} de plus de quelques centaines d'angström avant que cette dernière ne se relaxe en formant de nombreuses dislocations très dommageables pour sa qualité cristalline.

Il est connu que courber une structure modifie son paramètre de maille. Mais tirer parti de ce constat pour réaliser une épitaxie de qualité n'est pas immédiat. En effet, comment, sans modifier les bâtis d'épitaxie, pouvoir réaliser un substrat d'épitaxie de paramètre de maille adapté à partir d'un substrat donné mal adapté, et ce de façon précise et reproductible ?

### Exposé de l'invention

L'invention répond aux deux problèmes exposés ci-dessus.

Elle propose un procédé de réalisation d'une structure complexe par mise en contact et assemblage de deux structures élémentaires par deux faces respectives de liaison selon la revendication 1.

Ainsi, l'invention préconise de générer volontairement des contraintes dans une structure complexe assemblée pour lui permettre par exemple de compenser ensuite les contraintes qui seront générées lors des étapes technologiques ultérieures, et en particulier celles nécessitant des changements de température : cela autorise ensuite, de façon fiable et reproductible, des étapes technologiques impliquant de plus grands écarts de température ou de plus longue durée que précédemment.

Il est à noter que la présence de précontraintes dans l'hétérostructure entre les étapes successives (typiquement à température ambiante) n'a, en fait, aucun inconvénient substantiel.

Par ailleurs, l'invention permet de réaliser un support d'épitaxie autonome et adapté pour un matériau à épitaxier donné, sous la forme d'une structure complexe contrainte. Du fait des contraintes internes générées au sein de cette structure lors de l'assemblage, et plus particulièrement des contraintes en surface, on peut contrôler précisément le paramètre de maille en surface sans autre dispositif que l'autre partie de cette structure complexe. Ceci permet donc de réaliser une épitaxie de bonne qualité à partir de cette structure complexe contrainte.

Il est à noter que, dans un tout autre contexte, il est proposé dans la publication D. Feijoo, I. Ong, K. Mitani, W. S. Yang, S. Yu and U. M. Gösele, "Prestressing of bonded wafers", Proceedings of the 1 st international symposium on semiconductor wafer bonding, Science, Technology and applications, Vol. 92-7, The Electrochemical Society (1992) p.230, une méthode pour générer des contraintes internes au sein d'une structure complexe, mais non pas pour répondre à l'un des deux problèmes posés mais en vue de renforcer la stabilité mécanique de la structure.

Pour cela, deux structures, en l'occurrence deux plaques de silicium, sont collées par adhésion moléculaire dans des conditions standard. La structure complexe ainsi formée est ensuite contrainte par courbure. La courbure est provoquée par l'application d'un pointeau au centre de la structure, la structure étant maintenue fixe en sa périphérie. En courbant suffisamment la structure, l'interface de collage cède : les deux plaques se décollent puis se recollent aussitôt à la courbure atteinte. Ce processus de décollement/recollement peut s'opérer plusieurs fois en fonction de l'énergie de collage à l'interface et de la force appliquée grâce au pointeau. Lorsque les auteurs relâchent la contrainte due au pointeau, la structure complexe se relaxe et se stabilise à un rayon de courbure qui dépend de celui obtenu lors du dernier décollement/recollement de la structure complexe sous contrainte du pointeau. Des contraintes internes sont ainsi générées dans la structure complexe.

Mais ce document ne décrit ni même ne suggère de générer ces contraintes dans une structure complexe pour résoudre des problèmes de comportement en température, ni ajuster un paramètre de maille.

En outre, les contraintes internes générées dans la structure ne sont pas facilement ajustables par cette technique. En effet, elles sont dépendantes des valeurs relatives de l'énergie de déformation élastique de la structure et de l'énergie du collage. De plus, comme l'indique les auteurs, cette méthode ne peut être employée pour des collages moléculaires de trop forte énergie car, dans ces conditions, les deux structures assemblées ne parviennent pas à se décoller et, si on reste dans les limites de déformation élastique de la structure quand on retire le pointeau, la structure revient à son état initial au moment du collage moléculaire. Celle-ci ne présente alors aucune courbure et donc aucune contrainte interne. Or, il est souvent technologiquement intéressant d'avoir une forte énergie de collage afin d'assurer par exemple une bonne solidité et une bonne qualité de l'interface de collage.

La technique décrite dans ce document permet donc certes de générer des contraintes dans une structure complexe mais n'associe pas cette idée avec aucun des deux problèmes techniques précités. Ce n'est donc qu'a posteriori que ce document peut présenter des analogies avec l'invention. En tout état de cause, les décollements/recollements incontrôlés rendent la technique proposée difficilement ajustable. Elle reste de plus limitée à des structures assemblées avec des énergies de collage limitées.

Le procédé de l'invention ne présente pas ces limitations : l'état de contraintes généré au sein de la structure complexe dépend des contraintes générées indépendamment dans chaque structure élémentaire avant assemblage, contraintes qui nous le verrons sont précisément ajustables. Le procédé est donc reproductible et ajustable de façon fiable et précise. Les forces de collage entre les structures élémentaires ne sont plus limitées puisque la structure complexe n'a pas dans le cadre de notre procédé à se décoller.

La différence de contraintes tangentielles entre les faces à coller des deux structures élémentaires peut avantageusement être créée en déformant (principalement de façon élastique) chacune des dites structures avant assemblage. Une technique simple et facile à mettre en oeuvre pour générer des contraintes est de courber ces structures.

Selon un mode de réalisation préféré, les deux structures sont courbées de sorte que les deux faces à assembler soient respectivement concave et convexe. Elles peuvent par ailleurs être complémentaires, ou même respectivement sphérique concave et sphérique convexe.

Courber les structures pour générer des contraintes peut, par exemple, être mis en oeuvre par application de forces mécaniques localisées et/ou réparties sur les structures à déformer.

Selon un mode de réalisation préféré, on peut créer une différence de pression entre les deux faces de la structure à courber. Parmi les moyens de réaliser cette différence de pression et pour obtenir une structure élémentaire présentant une face à assembler, on peut citer l'aspiration de ladite structure sur une préforme concave de profil adapté choisi en fonction de celui à donner à la face à assembler et sur laquelle la structure repose localement en sa périphérie. Avantageusement, on pourra prévoir des joints pour améliorer l'étanchéité entre la structure et la préforme. On peut citer également l'aspiration de ladite structure à l'intérieur d'une cavité, la structure reposant localement en sa périphérie sur un joint bordant la cavité.

La structure élémentaire courbée peut être obtenue par déformation de cette structure entre deux préformes complémentaires, l'une concave, l'autre convexe de profils choisis en fonction de celui à donner à la face à assembler. Dans ce cas, il peut être prévu sur la préforme qui reçoit la structure élémentaire des canaux d'aspiration pour maintenir la structure courbée, une fois enlevée l'autre préforme. Cette autre préforme peut avantageusement être l'autre structure élémentaire à assembler déjà courbée selon le profil désiré.

Une autre alternative consiste à appliquer les forces mécaniques simultanément sur les deux structures à assembler, par exemple par déformation des deux structures entre deux préformes de profils choisis en fonction de ceux à donner aux faces à assembler.

De manière préférée :
- l'application de forces mécaniques sur l'un ou moins des substrats est effectuée à l'aide d'une préforme constituée d'un moule,
- cette préforme est constituée d'un moule poreux,
- l'application de forces mécaniques sur les substrats est effectuée à l'aide d'au moins une préforme déformable.

De manière préférentielle, l'assemblage entre les deux structures est un collage moléculaire permettant d'atteindre des forces d'adhésion importantes et une interface de bonne qualité soit directement (par exemple par traitement plasma, UV/Ozone ou par adhésion sous vide) ou de façon assistée par exemple par un traitement thermique. Dans ce cas, avant ou après création de la différence d'état de contraintes entre les deux faces à assembler, lesdites faces sont traitées afin de faciliter le collage ultérieur. Ces traitements peuvent consister par exemple en un polissage mécanique et/ou chimique, un traitement chimique, un traitement UV/Ozone, RIE (reactive ion etching), plasma, ou un recuit hydrogène.

Ainsi, selon d'autres dispositions préférées de l'invention, éventuellement combinées :
- l'assemblage entre les substrats est réalisé par contact direct, la surface d'au moins l'un des substrats étant aménagée en sorte d'éviter un piégeage d'air entre les surfaces assemblées,
- l'un au moins des substrats est percé,
- ce substrat est percé en son centre,
- l'un au moins des substrats comporte au moins un canal non traversant débouchant en bordure du substrat,
- l'assemblage entre les substrats est réalisé au moyen d'une couche de fluage,
- on réalise l'assemblage à une température supérieure à l'ambiante,
- les substrats sont chauffés par contact avec des préformes chauffées, et
- les préformes sont respectivement chauffées à des températures différentes.

Le procédé de l'invention peut comporter des étapes supplémentaires.

Ainsi, il peut inclure, en outre, une étape technologique comportant un changement de température. Dans ce cas, la différence d'état de contraintes tangentielles entre les deux faces à assembler est choisie de sorte que lors de cette étape technologique, les contraintes à l'intérieur de la structure assemblée atteignent ou avantageusement restent inférieures à un niveau de contraintes prédéterminé. Pour une étape de traitement thermique par exemple, le niveau de contraintes que l'on souhaite ne pas dépasser est choisi en sorte de permettre d'assurer la tenue mécanique de cette structure, à la température de traitement thermique par exemple.

Le procédé de l'invention peut comporter également, en outre, après assemblage des deux structures élémentaires, une étape d'amincissement de l'une de ces deux structures en un film mince. On peut, dans ce cas, choisir la différence d'état de contraintes tangentielles entre les deux faces à assembler de sorte d'imposer un niveau de contraintes donné au sein du film mince résultant. De manière avantageuse, on assemble le film mince à une autre structure élémentaire en créant, avant assemblage, une différence d'état de contraintes tangentielles entre les deux faces à assembler, cette différence étant choisie en sorte d'obtenir au sein de la nouvelle structure assemblée un état de contraintes prédéterminé dans des conditions données par rapport aux conditions d'assemblage.

Le procédé peut également comprendre en outre, une étape d'épitaxie pour réaliser un film épitaxié d'un matériau sur une face externe de la structure complexe. On choisit alors la différence d'état de contraintes tangentielles de sorte qu'à la température d'épitaxie, cette face externe présente un paramètre de maille choisi par avance et avantageusement compatible avec l'épitaxie du matériau désiré.

Avantageusement, la face sur laquelle doit s'opérer l'épitaxie est la face d'un film mince obtenu (voir ci-dessus) par amincissement d'une structure complexe contrainte obtenue par assemblage de deux structures élémentaires contraintes. On dispose alors d'un substrat d'épitaxie pratiquement plan.

Le substrat d'épitaxie peut être obtenu de manière plus complexe, permettant à partir d'un matériau donné, d'obtenir un substrat d'épitaxie de paramètre de maille très éloigné de ce matériau de départ.

Le procédé peut par exemple comprendre, en outre, les étapes suivantes :
- assemblage de la structure complexe comportant le film épitaxié sur une autre structure « élémentaire » par deux faces respectives de liaison en créant avant assemblage une différence d'état de contraintes tangentielles entre ces deux nouvelles faces à assembler,
- amincissement de la structure complexe pour libérer une face du film mince épitaxié,
- épitaxie d'un nouveau matériau à partir de la face du film mince libérée.

La différence d'état de contraintes tangentielles entre les deux nouvelles faces à assembler est alors choisie de sorte que le paramètre de maille du film mince épitaxié soit compatible avec l'épitaxie du nouveau matériau à épitaxier.

Ce procédé peut au besoin être réitéré pour obtenir un paramètre de maille toujours différent (croissant ou décroissant).

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés dans lesquels :
- la figure 1 illustre schématiquement un exemple de mise en oeuvre, non limitatif, du procédé selon l'invention,
- les figures 2, 3 et 4 illustrent des variantes de mises sous contraintes des structures élémentaires à assembler,
- les figures 5A et 5B sont deux exemples de conditionnement d'une structure élémentaire pour éviter l'emprisonnement de bulles d'air pendant l'assemblage,
- les figures 6A, 6B, 6C et 6D illustrent un procédé de mise sous contrainte d'un film mince par amincissement de structures complexes contraintes,
- les figures 7A et 7B présentent schématiquement l'évolution avec la température des contraintes aux deux surfaces d'un substrat en silicium au sein d'une structure complexe obtenue par assemblage, sans ou avec mise sous contraintes préalable, de substrats en silice et silicium,
- les figures 8A et 8B présentent schématiquement l'évolution des contraintes avec la température à l'interface de collage d'une couche mince en silicium d'une structure complexe obtenue par assemblage silicium-silice, sans ou avec mise sous contraintes préalable,
- les figures 9A à 9F illustrent la réalisation d'un substrat d'épitaxie de paramètre de maille donné, et
- la figure 10 est une vue schématique en coupe d'un couple de deux préformes déformables.

### Description détaillée de modes de réalisation de l'invention

### Collage courbé

Sur les figures auxquelles se réfère la description qui suit, des parties identiques, similaires ou équivalentes sont repérées avec les mêmes références numériques. Par ailleurs pour des raisons de clarté des figures, les différents éléments ne sont pas représentés selon une échelle homogène.

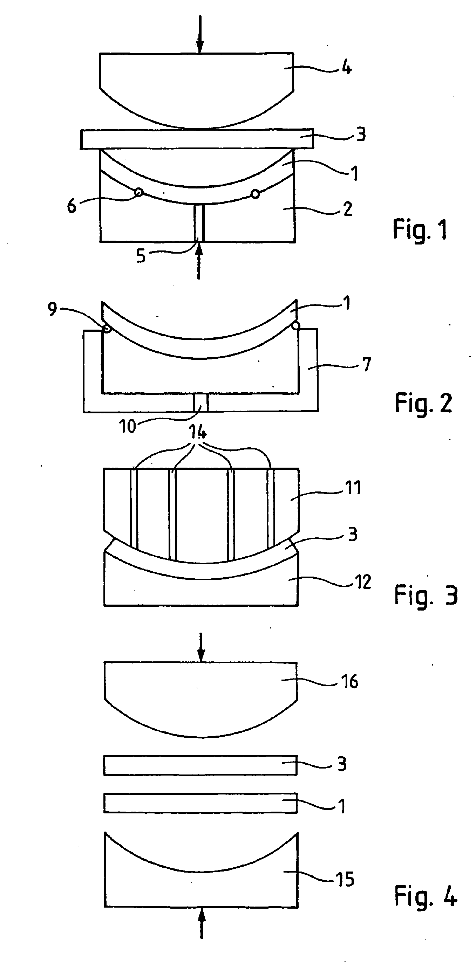

La figure 1 illustre un mode de réalisation non limitatif de l'invention. Une première structure élémentaire 1 est déformée par aspiration sur une première préforme 2 de forme spécifique, par exemple sphérique concave. L'aspiration est réalisée grâce à des canaux d'aspiration 5 débouchant à la surface de la préforme. Des joints 6 situés en périphérie de la préforme peuvent soutenir la première structure 1 et permettre d'assurer une différence de pression entre les deux faces de cette structure. Celle-ci, sous l'effet de cette différence de pression, se déforme pour épouser la forme de la première préforme 2. Du fait de la déformation, des contraintes connues et quantifiables par l'homme du métier naissent au sein de la première structure 1 et en particulier sur sa face libre (ici sa face supérieure).

Une deuxième structure 3 est alors mise en regard de la face libre de la première structure 1. Une deuxième préforme 4, de forme adaptée et avantageusement complémentaire de la forme de la première préforme 2, par exemple sphérique convexe, est prévue pour assurer la déformation de la deuxième structure 3 entre la deuxième préforme 4 et la première structure 1. La flèche représentée sur la figure 1 symbolise l'application des forces destinées à réaliser la déformation proprement dite. Au cours de la déformation, la deuxième structure 3 se déforme progressivement au contact de la première structure 1 jusqu'à en épouser la forme.

Les deux faces à assembler ayant été conditionnées, par exemple avant la mise sous contrainte des deux structures, de façon connue de l'homme du métier afin de permettre un collage par adhésion moléculaire, ce collage s'effectue lorsque les deux faces coïncident.

On obtient alors une structure complexe formées de l'assemblage de deux structures contraintes présentant au niveau de leurs faces assemblées une différence de contraintes tangentielles connue et imposée par la déformation respective des deux structures avant le collage.

L'homme du métier sait relier précisément la déformation imposée sur les structures avec le niveau de contraintes obtenues dans la structure et en particulier ceux obtenus sur les faces à assembler. Il sait donc par un choix adapté des formes des préformes 2 et 4 imposer précisément une différence de contraintes tangentielles entre les deux faces à assembler avant le collage et donc imposer les contraintes en tout point de la structure complexe une fois assemblée. Les préformes peuvent être par exemple des moules rigides, poreux ou non ou encore des membranes déformables.

Une variante du procédé consiste, comme illustré figure 2, à remplacer la première préforme 2 par un dispositif creux 7 muni d'une cavité centrale 8. La première structure 1 repose alors sur ce dispositif en sa périphérie par l'intermédiaire de joints étanches 9. Des canaux d'aspiration 10 permettent de créer dans la cavité une dépression. En ajustant la différence de pression qui s'applique entre les deux faces de la première structure 1, on peut ainsi déformer cette première structure 1 selon une courbure déterminée. Par exemple, pour un vide dans la cavité d'environ 0.25 bar, l'autre face de la structure étant soumise à la pression atmosphérique, on obtient 3 mm de flèche sur une plaque de 200 mm de diamètre standard de silicium d'épaisseur 750 µm avec un joint de diamètre 195 mm. La première structure 1 peut ensuite être assemblée à la seconde structure 3 comme expliqué précédemment.

Une autre variante est illustrée sur la figure 3. Elle consiste à réaliser la déformation de la seconde structure 3 entre deux préformes adaptées de formes complémentaires, l'une concave 12 et l'autre convexe 11. La préforme convexe est munie de canaux d'aspiration 14 pour permettre de maintenir la deuxième structure 3 dans sa position après la déformation et le retrait de la préforme concave 12. La deuxième structure 3 peut ensuite être assemblée à la première structure 1 elle-même déjà déformée, par un collage à l'aide d'une colle par exemple. Une autre variante consiste à assembler sans contrainte à température ambiante les deux structures élémentaires à assembler par un collage moléculaire. On déforme ensuite cette structure assemblée entre deux moules complémentaires. On s'assure ensuite que chacune des structures est solidaire d'un des moules (par aspiration par exemple) puis on provoque par tout moyen connu de l'homme du métier une séparation de la structure assemblée au niveau de la zone de collage moléculaire. On obtient alors deux structures élémentaires contraintes que l'on peut ensuite assembler selon l'invention. Cette variante a pour avantage de préserver l'état de surface au niveau des faces à assembler, permettant ainsi par exemple, d'assembler les deux structures élémentaires contraintes par un nouveau collage moléculaire.

Plus généralement, l'assemblage des deux structures élémentaires peut donc s'effectuer par un collage par adhésion moléculaire, un collage au moyen d'une colle ou encore d'une couche de scellement.

On pourra par ailleurs prévoir d'utiliser une couche d'adhésion entre la préforme et la structure à déformer ou encore utiliser des forces électrostatiques ou magnétiques pour maintenir en contact la préforme et la structure élémentaire courbée.

Selon encore une autre variante illustrée figure 4, on met en vis à vis les deux structures 1 et 3 sans qu'elles soient collées et on les déforme simultanément entre deux préformes respectivement concave 15 et convexe 16 de formes complémentaires. Les flèches sur la figure 4 illustrent les forces de pression à appliquer pour assurer la déformation. Les deux structures se déforment alors conjointement, un film d'air restant interposé entre les deux structures. Une fois atteinte la courbure désirée, le film d'air s'évacue et du fait des forces appliquées, le collage par adhésion moléculaire s'effectue alors.

De manière préférée, les deux structures sont initialement planes et d'épaisseur constante. On comprend néanmoins que les structures peuvent aussi avoir des géométries initialement différentes (à l'état relaxé), par exemple non planes, de sorte qu'elles peuvent subir des précontraintes d'amplitudes différentes au moment de l'assemblage.

### Bulles d'air

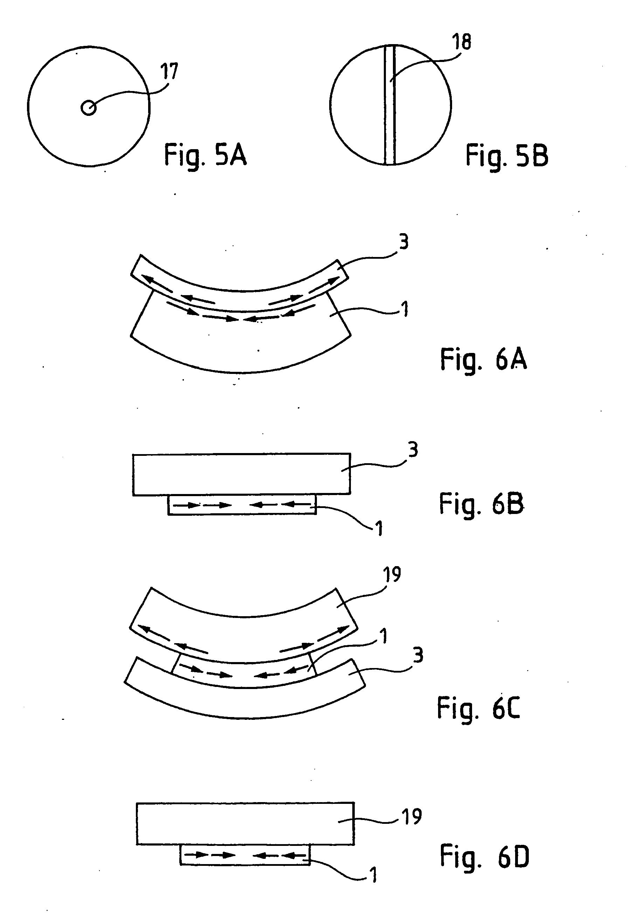

Lors de la déformation de la deuxième structure 3 entre la première structure 1 et la préforme 4, une bulle d'air peut se trouver emprisonnée entre les deux structures et gêner le collage par adhésion moléculaire. Pour évacuer cette bulle d'air, on peut avantageusement prévoir de percer en leur centre 17, comme illustré figure 5A, l'une ou les deux structures à assembler par un perçage laser par exemple ou une gravure profonde de la structure. On pourra avantageusement prévoir des moyens d'aspiration pour faciliter l'évacuation de la bulle d'air au niveau de ce perçage.

Une alternative consiste à prévoir sur l'une ou les deux structures un ou plusieurs canaux d'évacuation 18 sur la face à assembler, débouchant en bordure de plaque comme illustré sur la figure 5B. Ces canaux peuvent, par exemple, avoir des dimensions de l'ordre de 100 µm de largeur et 5 µm de profondeur et être réalisés par les techniques usuelles de lithographie et de gravure. On pourra avantageusement prévoir des moyens d'aspiration pour aspirer au niveau des trous débouchant l'air emprisonné.

Une autre alternative peut consister à réaliser la déformation et l'assemblage sous un vide partiel afin de minimiser le volume d'air emprisonné, même si cette méthode a l'inconvénient de nécessiter des vides d'autant plus poussés pour assurer la déformation par dépression des structures.

Parmi les autres options, on peut aussi citer celle qui consiste à placer des espaceurs en position radiale en périphérie de plaque, qui seront retirés une fois la zone centrale collée. Plus généralement, on pourra utiliser toute méthode qui permet d'initier le collage entre les deux structures en leurs centres pour ensuite le propager vers les bords. On pourra pour cela, par exemple, introduire avant collage une légère différence de rayon de courbure entre les deux structures.

### Définition de la structure

Les procédés décrits précédemment permettent donc de réaliser une structure complexe par assemblage de deux structures élémentaires en imposant avant collage une différence de contraintes tangentielles sur les faces à assembler.

Par structure élémentaire à assembler, on entend un substrat plus ou moins épais, simple ou composite (formé d'un empilement de différentes couches d'un ou plusieurs matériaux plus ou moins minces), processé ou non. Les matériaux concernés sont tous les semi-conducteurs, comme notamment le silicium, le germanium, leurs alliages Si₁₋ₓGeₓ, le phosphure d'indium (InP), l'arseniure de gallium (GaAs), le niobate de lithium, le carbure de silicium (SiC), le nitrure de gallium (GaN), le saphir, les supraconducteurs comme par exemple les composés de type YbaCuO, NbN, ou BiSrCaCuO, tous les isolants comme notamment, la silice fondue, le quartz, les verres de différentes compositions, MgO, tous les métaux comme notamment le tungstène, le cuivre ou l'aluminium.

### Enlèvement des préformes

On obtient après collage, selon le procédé de l'invention, une structure complexe contrainte dont les contraintes sont connues en tout point et ce, en imposant une différence de contraintes tangentielles entre les faces des deux structures à assembler. Lorsqu'on supprime les forces qui ont permis de déformer les deux structures initiales (pression mécanique ou aspiration par le vide), avec la libération des faces extérieures de la structure complexe, les contraintes au sein de cette structure évoluent mais ce, de façon déterminée et connue de l'homme du métier. Cette évolution est fonction, entre autre, des natures et des épaisseurs des différents matériaux constituant chacune des deux structures initiales et de la différence de contraintes présente à l'interface de collage.

### Amincissement

La figure 6A illustre la structure complexe obtenue après assemblage d'une première structure 1 et d'une deuxième structure 3 dans le cas où la première structure 1 est déformée par une préforme sphérique concave et la deuxième structure 3 par une préforme sphérique convexe. Dans ce cas, la face assemblée de la première structure 1 est sphérique concave : cette face est donc en compression. La face assemblée de la deuxième structure 3 est sphérique convexe et est donc en traction. Les flèches présentes sur la figure 6A matérialisent les contraintes internes tangentielles au sein de la structure complexe au niveau des faces assemblées.

Si on procède à un amincissement de l'une des structures 1 ou 3, les contraintes internes au sein de la structure complexe vont à nouveau évoluer et ce, de façon prévisible et connue de l'homme du métier. Si on amincit la première structure 1 par exemple, la deuxième structure 3 aura tendance à se relaxer, c'est à dire à retrouver sa planéité étant de moins en moins contrainte par la première structure 1 amincie. Ceci se traduit par une diminution des contraintes sur la face assemblée de cette deuxième structure 3, engendrant du fait du collage, une augmentation des contraintes sur la face assemblée de la première structure 1. Si on poursuit l'amincissement jusqu'à obtenir un film mince de la première structure 1, on obtient, comme illustré sur la figure 6B, une deuxième structure 3 presque plane, libre de pratiquement toute contrainte, assemblée à un film mince de la première structure 1 au sein duquel les contraintes internes sont relativement homogènes et plus élevées que celles présentes sur la face assemblée de la structure 1 avant amincissement.

Cette méthode peut, si on le souhaite, être réitérée autant de fois que nécessaire pour obtenir une contrainte donnée à l'intérieur d'un film mince. Ainsi, partant de l'exemple précédent par exemple, on assemble à nouveau la structure obtenue (formée de la couche mince issue de la première structure 1 collée sur la deuxième structure 3) avec une autre structure 19 après mises sous contraintes de ces deux structures. Avantageusement, la structure contenant le film mince est courbée de sorte que ce film mince soit encore plus comprimé avant collage, par exemple par courbure par une préforme concave, comme illustré figure 6C. La structure 19 est, elle, contrainte par une préforme convexe de sorte que sa face à assembler à la face libre du film mince 1 est en dilatation. On procède ensuite à l'amincissement (voire à la suppression), par exemple par des moyens mécaniques, de la deuxième structure 3. Comme expliqué précédemment, la structure 19 se relaxe progressivement et on obtient au final un film mince issu de la première structure 1 au sein duquel les contraintes internes ont été encore accrues, reporté sur une structure 19 relaxée, comme illustré figure 6D.

Ce procédé permet donc d'obtenir un film mince, de silicium par exemple, contraint en traction ou en compression à un niveau de contraintes désiré. Ces films contraints ont des applications en microélectronique, en particulier dans le domaine des hautes fréquences, les porteurs présentant alors une plus grande mobilité.

L'amincissement de telles structures complexes contraintes est réalisé selon un procédé standard d'amincissement de la microélectronique, la structure complexe peut en effet être si nécessaire remise dans un état plan par aspiration au niveau d'un support au moment du polissage mécanique par exemple.

### Traitement thermique d'une hétérostructure

Nous avons établi qu'il est important de contrôler l'évolution des contraintes au sein d'une hétérostructure lorsque les différents matériaux qui la composent présentent des coefficients de dilatation thermique différents. En effet, cette différence est susceptible d'endommager l'hétérostructure lors d'un changement important de température. Ce changement de température peut être rendu nécessaire pour consolider un collage par exemple, ou encore pour réaliser des étapes technologiques pour la fabrication de composants microélectroniques (épitaxie ou traitement thermique par exemple).

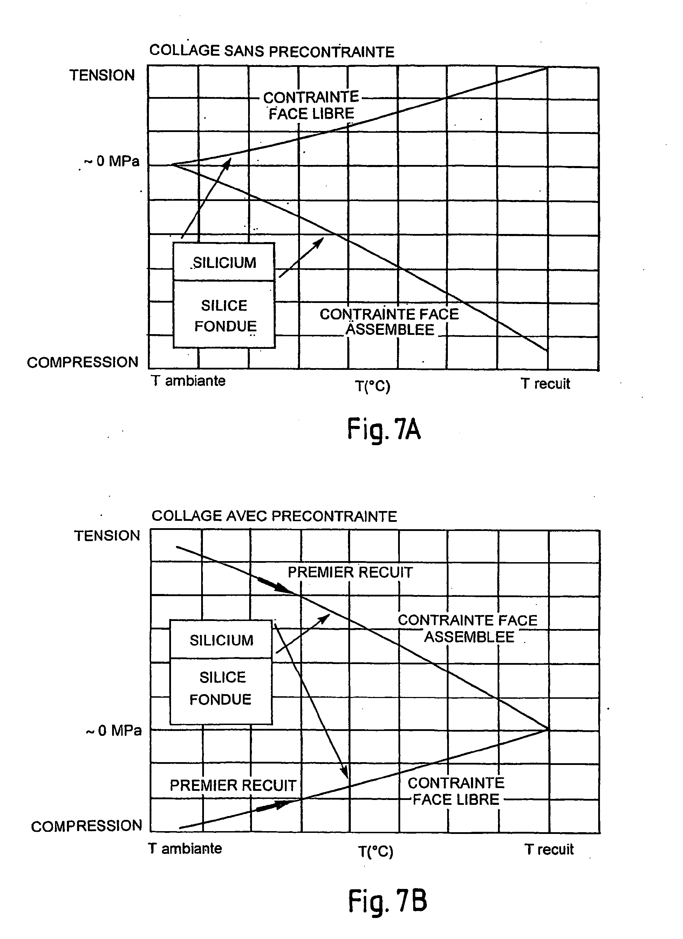

Considérons, par exemple, une hétérostructure formée d'une couche de silicium (typiquement de 750 µm) collée sur un substrat de silice fondue (typiquement de l'ordre de 1200 µm) par un collage par adhésion moléculaire sans contrainte préalable. La figure 7A illustre l'évolution des contraintes sur les deux faces du silicium, la face assemblée et la face libre, en fonction de la température au cours d'un traitement thermique par exemple. Le silicium ayant un coefficient de dilatation thermique plus élevé que la silice fondue, lorsque la température s'élève, la face assemblée du silicium est gênée dans son expansion par la silice fondue, qui se dilate moins que le silicium. Cette face est donc entraînée en compression, provoquant, du fait de la raideur du silicium, la dilatation de sa face libre. Si cette évolution n'est pas contrôlée, elle peut engendrer des contraintes internes au sein de la structure pouvant endommager ou même détruire cette structure.

On atteint ainsi, dans le cadre de notre exemple, pour une température de traitement thermique de l'ordre de 400°C, des contraintes en compression de l'ordre de 100MPa pour la face assemblée du silicium et des contraintes en dilatation de l'ordre de 60MPa pour sa face libre.

Cette évolution des contraintes avec la température est parfaitement connue et quantifiable par l'homme du métier. Elle est décrite notamment dans les documents suivants : S. Timoshenko, J. Opt. Soc. Am. 11 (1925) p.233 et D. Feijoo, I. Ong, K. Mitani, W. S. Yang, S. Yu and U. M. Gösele, Zhe-Chuan Feng and Hong-du Liu J; Appl. Phys. 54(1), 1983, p.83 "Generalized formula for curvature radius and layer stresses caused by thermal strain in semiconductor multilayer structures". En première approximation par des calculs de mécanique en théorie élastique continue, si on considère isotropes les matériaux et constants les coefficients de dilatation thermique sur la plage de température à couvrir, l'évolution des contraintes est approximativement linéaire avec la température, comme illustré sur les figures 7A et 7B. Des calculs plus complexes (par exemple par éléments finis) permettent d'affiner les résultats.

On peut donc par un calcul inverse définir quelles contraintes sont nécessaires à température ambiante au sein de la structure complexe pour rester, dans la gamme de température d'utilisation de cette structure (jusqu'à la température de traitement thermique par exemple), dans une gamme de contraintes acceptable. On peut également faire en sorte, par un choix adapté d'assemblage sous contraintes, de minimiser et même d'annuler les contraintes au sein d'une structure composite à une température donnée, par exemple celle de traitement thermique. C'est ce qui est illustré figure 7B dans le cadre de notre exemple.

On procède alors à l'assemblage selon l'invention en courbant avant collage les structures de silice fondue et de silicium, la face à assembler du silicium étant en dilatation (convexe par exemple), celle de la silice fondue étant en compression (concave par exemple). Après collage, à température ambiante, l'hétérostructure résultante présente des pré-contraintes internes déterminées, dans la couche de silicium en particulier et un rayon de courbure d'environ 1,18 m (après relâchement des forces nécessaires pour imposer la courbure). Ces pré-contraintes au sein du silicium sont choisies de sorte qu'elles compensent tout ou partie de l'action en compression de la silice fondue sur le silicium lors de l'élévation de température. Elles peuvent même être choisies en sorte de permettre d'annuler les contraintes au sein de la structure de silicium à la température de traitement thermique choisie. Ce traitement thermique peut en effet être nécessaire, par exemple pour renforcer le collage silice fondue/silicium.

On a vu qu'on peut également contrôler l'évolution des contraintes au sein d'un film mince lors de l'évolution en température d'une hétérostructure formée de ce film mince collé sur un substrat épais d'un matériau différent. Dans ce cas, seul le film mince est contraint, le substrat restant du fait de sa taille, pratiquement relaxé et contraignant le film mince.

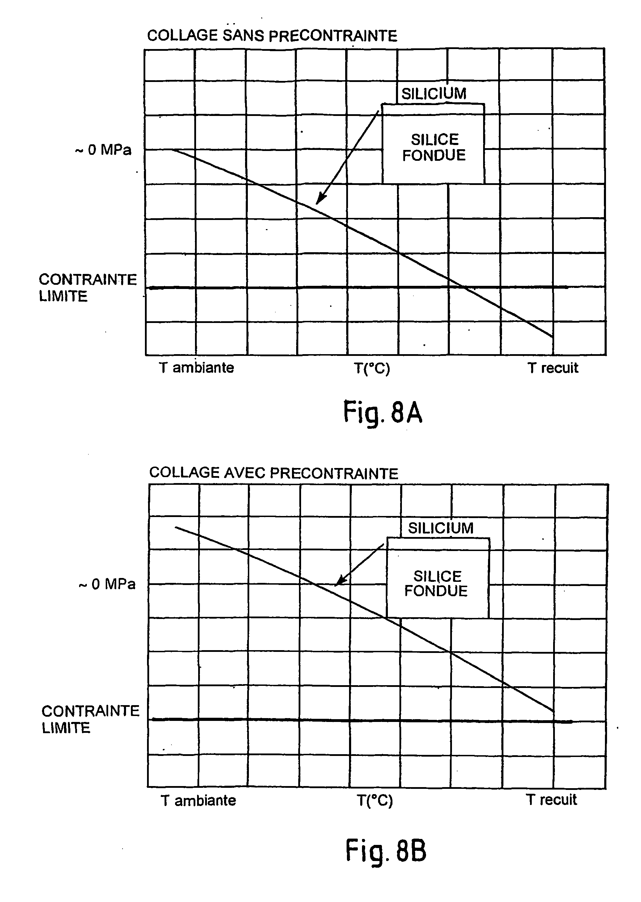

Considérons par exemple un film mince de silicium (typiquement de 0,4 µm) sur un substrat en silice fondue de 1200 µm d'épaisseur. La figure 8A montre l'évolution des contraintes dans le film de silicium. Si on part d'une hétérostructure obtenue par un collage sans précontrainte, le film de silicium se comprime de plus en plus quand la température augmente. On atteint ainsi, pour un film de 0.4µm de silicium assemblé sur un substrat de 1200 µm de silice fondue, à la température de 600°C, des contraintes en compression au sein du film mince de l'ordre de 500 Mpa, qui peuvent approcher, voire dépasser, la contrainte limite fixée.

On peut prévoir, en utilisant le procédé objet de l'invention, de précontraindre le film mince de silicium avant collage de sorte que ce film soit suffisamment en tension après collage, pour compenser tout ou partie de la compression occasionnée par la silice lors de l'élévation de température. On peut ainsi rester dans une gamme de contraintes acceptable pour le film de silicium.

Dans le cadre de notre exemple, si l'on souhaite effectuer un traitement thermique à 800°C sans dépasser un niveau de contraintes limite que l'on s'est ici fixé à 500 MPa, il suffit pour cela, par exemple, d'introduire à température ambiante, une courbure d'environ 1.25 m sur un substrat SOI (comportant en surface un film de silicium de 0,4 µm) le silicium ainsi que sur le substrat de silice fondue de sorte que les faces à assembler du substrat SOI et de la silice fondue soient respectivement en dilatation (convexe par exemple) et en compression (concave par exemple) avant collage. Après collage et libération des contraintes extérieures, la structure complexe se relaxe avec un rayon de courbure final d'environ 1,25 m. On amincit alors le substrat SOI jusqu'à libérer le film mince de silicium ; la silice fondue se relaxe, accroissant le niveau de contraintes en dilatation du film mince de silicium. Cette dilatation viendra, par la suite, compenser pour tout ou partie les contraintes en compression au sein du film mince engendrées par l'élévation en température de la structure. Elles permettront ainsi de rester sous le seuil de contraintes fixé. On pourrait, par une méthode similaire, accroître le niveau de contraintés dans le film mince de silicium et ainsi obtenir un film mince de silicium contraint.

### Paramètre de maille

Une autre application importante de l'assemblage sous contrainte est l'adaptation du paramètre de maille d'un matériau au paramètre de maille d'un autre matériau en vue par exemple de l'épitaxie de ce dernier sur le premier. Il est connu de l'homme du métier qu'en courbant un substrat, on fait évoluer son paramètre de maille, en particulier en surface. Le procédé, objet de l'invention, permet de réaliser une structure courbée facilement manipulable, sans nécessité après assemblage d'un dispositif extérieur pour la contraindre. Celle-ci est donc directement compatible avec les machines de dépôt par épitaxie sous ultra-vide par exemple. En choisissant avant collage des niveaux de contraintes adaptés, la structure possède alors en surface une courbure donnée et donc un paramètre de maille adapté à la température d'épitaxie, en prenant en compte les différences éventuelles de coefficient de dilatation thermique.

L'invention permet également de réaliser un film mince contraint assemblé sur un substrat, les contraintes internes du film mince étant choisies en sorte d'obtenir sur ce film un paramètre de maille adapté au matériau à épitaxier et ce, à la température d'épitaxie. Le procédé permettant d'obtenir un film mince contraint a été décrit précédemment et peut au besoin être réitéré pour obtenir un niveau de contrainte donné au sein du film mince.

On prendra également en compte, s'il y a lieu, les phénomènes de dilatation thermique au sein de la structure.

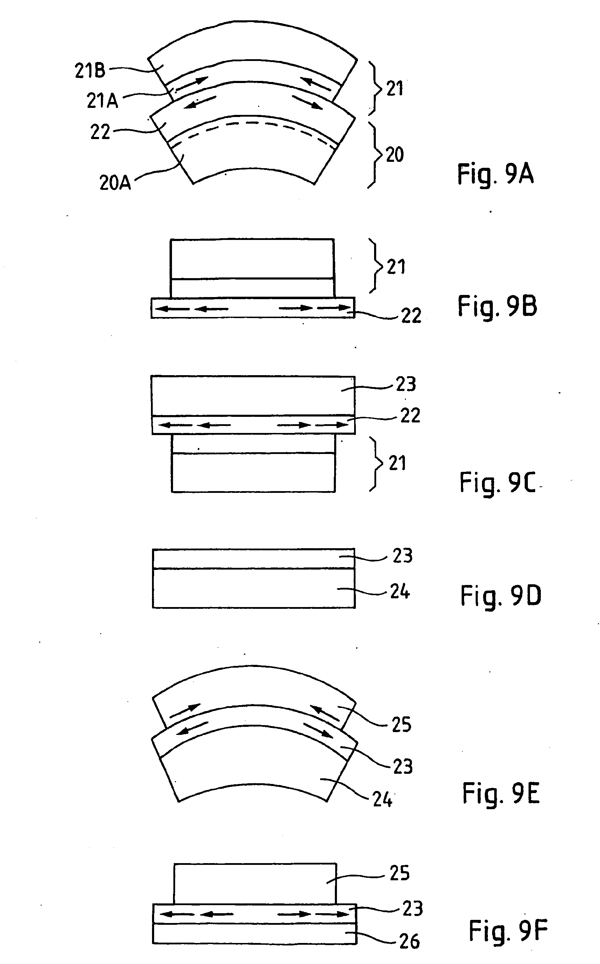

Les figures 9A à 9F illustrent pratiquement un tel procédé. Sur la figure 9A, on colle sous contrainte un substrat SOI repéré 20 (formé d'une couche 22 de silicium sur un substrat 20A formé d'un substrat silicium et d'une couche d'oxyde) et un substrat de silicium oxydé sur 400nm repéré 21 (formé d'une couche 21A de silice sur une couche 21B de silicium), la face à assembler du SOI étant en dilatation, celle du silicium oxydé en compression. Après retrait des forces nécessaires pour obtenir les courbures, la structure complexe a un rayon de courbure d'environ 1m. On effectue ensuite, comme illustré figure 9B, un retrait du substrat 20A par des moyens mécano-chimiques. Il peut subsister le film d'oxyde du substrat 20A, délimité par la ligne pointillée de la figure 9A Ce film d'oxyde peut au besoin être retiré. Le film de silicium 22 ainsi transféré sur le silicium oxydé 21 est alors contraint à une valeur moyenne en tension d'environ 180 Mpa formant ainsi une nouvelle structure SOI. Son paramètre de maille a alors varié d'environ 0,14%. Ce paramètre de maille permet de déposer, comme illustré figure 9C, sur ce film mince 22, un film 23 de SiGe avec une concentration d'environ 3.5% de germanium par rapport au silicium et ce, sans désaccord de paramètre de maille. A cette concentration en germanium, on peut tolérer un écart de plus ou moins 0.5% en germanium, tout en restant compatible avec la croissance d'une couche de 200nm. On obtient pour le SiGe une très bonne homogénéité d'épaisseur et une très bonne qualité cristalline. Le film de SiGe n'est alors pas contraint puisque son paramètre de maille est respecté.

Pour augmenter la concentration de l'alliage SiGe en germanium, on peut choisir, au lieu de déposer le SiGe 3.5%, de contraindre davantage le film de silicium déjà contraint en effectuant un nouveau collage sous contrainte comme expliqué précédemment.

On peut choisir également de renouveler le procédé de collage sous contrainte sur le SiGe 3.5%. On peut procéder pour cela, tout d'abord, au report du film mince 23 de SiGe 3.5% sur un support relaxé 24 selon une technique classique de la microélectronique (collage puis amincissement mécanique par exemple). On obtient alors la nouvelle structure illustrée figure 9D. Puis on courbe, par exemple, cette nouvelle structure comprenant le film mince de SiGe reporté 23, et une autre structure 25, de silicium par exemple, avant de procéder au collage de ces deux structures, comme illustré figure 9E. On peut également coller directement la structure de la figure 9C sur cette nouvelle structure 25 après courbures. On choisit les niveaux de contraintes de sorte que le film mince 23 de SiGe se dilate. On procède ensuite au retrait du support 24 sur lequel le film mince 23 de SiGe avait précédemment été reporté ou dans le cas du collage direct au retrait des couches 21 et 22. Ceci accroît encore la dilation du film mince 23 de SiGe, comme illustré figure 9F. On augmente ainsi son paramètre de maille. Celui-ci devient alors compatible avec un dépôt 26 de SiGe à plus forte concentration de germanium. Cette technique permet de limiter les contraintes dans le film servant à l'épitaxie : en effet, les contraintes dans le film de SiGe après collage sous contraintes sont moins importantes que celles qui seraient nécessaires dans le film de silicium pour obtenir le même paramètre de maille.

On peut, par ce procédé, obtenir par exemple facilement du SiGe à 20% de concentration de germanium et ce sans limitation d'épaisseur et avec une très bonne homogénéité cristalline.

### Collage à chaud

Diverses variantes de ce qui précède sont possibles.

Les préformes peuvent être chauffées pour permettre un collage en température des structures intermédiaires déformées. Avantageusement, les préformes peuvent ne pas être à la même température pour que les deux structures intermédiaires présentent une différence de température au moment de l'assemblage.

Le fait de coller les structures intermédiaires en température permet aussi de contrôler les contraintes internes de la structure complexe en plus du contrôle déjà permis par la déformation contrôlée des structures intermédiaires.

Il est alors, par exemple, possible d'annuler des contraintes internes d'une structure complexe à une température donnée en limitant la déformation des structures intermédiaires. Par exemple, on ne veut pas déformer à plus de 1,4m de rayon de courbure les deux structures intermédiaires constituées d'une plaque de silicium de 750 µm d'épaisseur et de 200 mm de diamètre et d'une plaque de silice fondue de 1200 µm d'épaisseur et de 200 mm de diamètre. Ces deux structures intermédiaires déformées à environ 1,4 m avant collage donnent une structure complexe où les contraintes internes sont annulées en environ 300°C si le collage a eu lieu à 20°C. En revanche, si on colle les deux structures intermédiaires à 100°C, les contraintes internes de la structure complexe s'annuleront à 380°C, donc à une température plus haute sans avoir à déformer de façon plus importante les structures intermédiaires.

### Couche de fluage

On peut disposer entre les deux structures intermédiaires une couche qui flue à une certaine température, Tf. Le fait d'introduire cette couche de fluage permet de modifier les contraintes internes au sein de la structure complexe si la température du traitement thermique dépasse Tf.

Cela permet par exemple de minimiser des contraintes lors d'un recuit. Considérons par exemple une structure complexe constitué d'un substrat de silice fondue de 1200 µm d'épaisseur et de 200 mm de diamètre sur lequel on a un film de 0,4 µm de silicium. Le fait de créer la structure complexe avec l'invention permet de pouvoir atteindre une température de traitement thermique, Ttth, par exemple 800°C sans dépasser le niveau de contrainte que l'on s'est fixé pour conserver une bonne qualité cristalline au film de silicium (sans précontraindre les structures élémentaires pour former la structure complexe, on ne pouvait pas atteindre 800°C sans abîmer le film de silicium). En revanche, si on veut augmenter la température du traitement thermique sans modifier la déformation des structures élémentaires utilisée pour obtenir la structure complexe, on risque alors de dépasser le niveau de contrainte que l'on s'est fixé. Si on dispose d'une couche qui flue à Tf, avec Tf égale par exemple à 800°C, dès que la température de traitement thermique va dépasser Tf, la couche de fluage va fluer, relaxant ainsi une partie des contraintes internes. On peut alors effectuer un traitement thermique à une température supérieure à Ttth sans dépasser le niveau de contrainte interne que l'on s'est fixé.

### Travail sous pression

Les préformes peuvent être des moules, par exemple des moules poreux.

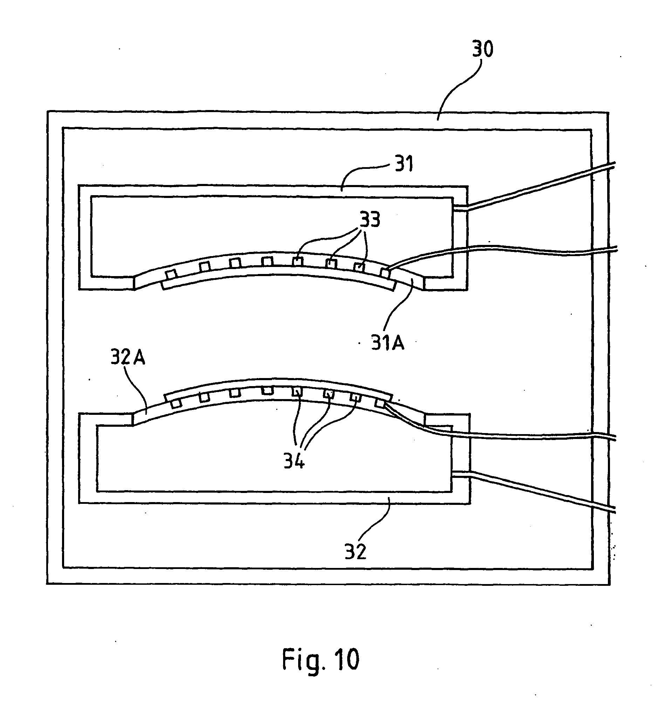

Lorsque l'on utilise un système de différence de pression pour déformer les structures élémentaires ou maintenir les structures élémentaires sur les préformes, il peut être avantageux qu'une des faces des structures élémentaires ne soit pas à la pression atmosphérique mais à une pression différente, avantageusement supérieure. La figure 10 représente à titre d'exemple une enceinte 30 contenant deux préformes 31 et 32 comportant chacune une membrane déformable 31A ou 32A. A la surface de ces membranes débouchent des canaux d'aspiration 33 et 34, ici schématisés comme étant tangentiels. Les circuits d'aspiration ou de mise sous pression sont schématisés par de simples double traits.

Les canaux d'aspiration permettent de maintenir les structures élémentaires déformées ; on peut limiter la surface des canaux d'aspiration en soumettant la face libre de la structure intermédiaire à une pression supérieure à la pression atmosphérique (par exemple 2 bar à l'intérieur de l'enceinte). Par ailleurs, si cette préforme déformable est déformée par une différence de pression, on peut atteindre une déformation plus importante en augmentant la pression sur la face libre de la structure élémentaire. A titre d'exemple, la préforme 31 est à une pression interne de 1,5 bar tandis que les canaux 33 sont à une pression de 0,3 bar ; la préforme 32 est à une pression interne de 2,5 bar tandis que les canaux 34 sont à une pression de 0,3 bar. La pression de l'enceinte (2 bar) est intermédiaire entre les pressions des préformes 31 et 32.

Le procédé de l'invention peut être mis en oeuvre sous diverses atmosphères, contrôlées ou non. En particulier il peut être mis en oeuvre sous hydrogène.

## Revendications

1. Procédé de réalisation d'une structure complexe selon lequel on met en contact et on assemble deux structures élémentaires (1, 3 ; 1, 3, 19 ; 20, 21, 23, 25 par deux faces respectives de liaison), **caractérisé en ce que**, avant mise en contact, on crée une différence d'état de contraintes tangentielles entre les deux faces à assembler, imposée en courbant chacune des deux structures élémentaires à assembler, par application de forces mécaniques sur chacune des deux structures, cette différence étant choisie en sorte d'obtenir au sein de la structure assemblée un état de contraintes prédéterminé dans des conditions données par rapport aux conditions d'assemblage.

2. Procédé de réalisation d'une structure complexe selon la revendication 1, **caractérisé en ce que** l'on déforme l'une des structures avant mise en regard de la seconde.

3. Procédé de réalisation d'une structure complexe selon la revendication 1 ou la revendication 2, **caractérisé en ce que** la différence d'état de contraintes est générée au moyen de contraintes générées indépendamment dans chaque structure élémentaire.

4. Procédé de réalisation d'une structure complexe selon l'une quelconque des revendication 1 à 3, **caractérisé en ce que** les deux structures sont courbées de sorte que les deux faces à assembler soient respectivement concave et convexe.

5. Procédé de réalisation d'une structure complexe selon la revendication 4, **caractérisé en ce que** les deux structures sont courbées de sorte que les deux faces à assembler soient complémentaires.

6. Procédé de réalisation d'une structure complexe selon la revendication 5, **caractérisé en ce que** les deux structures sont courbées de sorte que les deux faces à assembler soient respectivement sphérique concave et sphérique convexe.

7. Procédé de réalisation d'une structure complexe selon l'une quelconque des revendications 1 à 6, **caractérisé en ce que** les forces mécaniques appliquées sur la structure élémentaire résultent de la création d'une différence de pression entre les deux faces de ladite structure.

8. Procédé de réalisation d'une structure complexe selon la revendication 7, **caractérisé en ce que** la différence de pression entre les deux faces de la structure à courber pour qu'elle présente une face à assembler concave est créée par aspiration de ladite structure sur une préforme concave de profil adapté choisi en fonction de celui à donner à la face à assembler et sur laquelle la structure repose localement en sa périphérie.

9. Procédé de réalisation d'une structure complexe selon la revendication 7, **caractérisé en ce que** la différence de pression entre les deux faces de la structure à courber pour qu'elle présente une face à assembler concave est créée par aspiration de ladite structure à l'intérieure d'une cavité, la structure reposant localement en sa périphérie sur un joint bordant la cavité.

10. Procédé de réalisation d'une structure complexe selon la revendication 6, **caractérisé en ce que** les forces mécaniques appliquées résultent de la déformation de la structure entre une première et une deuxième préformes complémentaires, l'une concave, l'autre convexe, de profils choisis en fonction de celui à donner à la face à assembler.

11. Procédé de réalisation d'une structure complexe selon la revendication 10, **caractérisé en ce que** la première préforme est une des structures concaves à assembler déjà courbée selon le profil choisi.

12. Procédé de réalisation d'une structure complexe selon la revendication 10 ou la revendication 11, **caractérisé en ce que** la deuxième préforme est munie de canaux d'aspiration pour maintenir la structure courbée une fois enlevée la première préforme.

13. Procédé de réalisation d'une structure complexe selon l'une quelconque des revendications 1 à 6, **caractérisé en ce que** les forces mécaniques sont appliquées simultanément sur les deux structures à assembler par déformation des deux structures entre deux préformes de profils choisis en fonction de ceux à donner aux faces à assembler.

14. Procédé de réalisation d'une structure complexe selon l'une quelconque des revendications 1 à 13, **caractérisé en ce que** l'application de forces mécaniques sur l'un ou moins des substrats est effectuée à l'aide d'une préforme constituée d'un moule.

15. Procédé de réalisation d'une structure complexe selon la revendication 14, **caractérisé en ce que** cette préforme est constituée d'un moule poreux.

16. Procédé de réalisation d'une structure complexe selon l'une quelconque des revendications 1 à 13, **caractérisé en ce que** l'application de forces mécaniques sur les substrats est effectuée à l'aide d'au moins une préforme déformable.

17. Procédé de réalisation d'une structure complexe selon l'une quelconque des revendications 1 à 13, **caractérisé en ce que** l'assemblage entre les deux structures est un collage moléculaire.

18. Procédé de réalisation d'une structure complexe selon la revendication 14, **caractérisé en ce que** les deux faces à assembler sont traitées afin de faciliter le collage.

19. Procédé de réalisation d'une structure complexe selon l'une quelconque des revendication 1 à 18, **caractérisé en ce que** l'assemblage entre les substrats est réalisé par contact direct, la surface d'au moins l'un des substrats étant aménagée en sorte d'éviter un piégeage d'air entre les surfaces assemblées.

20. Procédé de réalisation d'une structure complexe selon la revendication 19, **caractérisé en ce que** l'un au moins des substrats est percé.

21. Procédé de réalisation d'une structure complexe selon la revendication 20, **caractérisé en ce que** ce substrat est percé en son centre.

22. Procédé de réalisation d'une structure complexe selon la revendication 21, **caractérisé en ce que** l'un au moins des substrats comporte au moins un canal non traversant débouchant en bordure du substrat.

23. Procédé de réalisation d'une structure complexe selon l'une quelconque des revendications 1 à 16, **caractérisé en ce que** l'assemblage entre les substrats est réalisé au moyen d'une couche de fluage.

24. Procédé de réalisation d'une structure complexe selon l'une quelconque des revendications 1 à 23 **caractérisé en ce qu'**on réalise l'assemblage à une température supérieure à l'ambiante.

25. Procédé de réalisation d'une structure complexe selon la revendication 24, **caractérisé en ce que** les substrats sont chauffés par contact avec des préformes chauffées.

26. Procédé de réalisation d'une structure complexe selon la revendication 25, **caractérisé en ce que** les préformes sont respectivement chauffées à des températures différentes.

27. Procédé de réalisation d'une structure complexe selon l'une quelconque des revendications 1 à 26, **caractérisé en ce que** le procédé inclut, en outre, une étape technologique comportant un changement de température, la différence d'état de contraintes tangentielles entre les deux faces à assembler étant choisie de sorte que, lors de cette étape, les contraintes à l'intérieur de la structure assemblée restent inférieures à un seuil de contraintes prédéterminé.

28. Procédé de réalisation d'une structure complexe selon la revendication 27, **caractérisé en ce que** l'étape technologique est une étape de traitement thermique.

29. Procédé de réalisation d'une structure complexe selon l'une quelconque des revendications 1 à 28, **caractérisé en ce que** le procédé inclut, en outre, après assemblage des deux structures élémentaires, une étape d'amincissement de l'une de ces deux structures en un film mince, la différence d'état de contraintes tangentielles entre les deux faces à assembler étant choisie en sorte d'imposer un niveau de contrainte donné au sein du film mince résultant

30. Procédé de réalisation d'une structure complexe selon la revendication 29, **caractérisé en ce que** l'on assemble le film mince à une autre structure élémentaire en créant, avant assemblage, une différence d'état de contraintes tangentielles entre les deux faces à assembler, cette différence étant choisie en sorte d'obtenir au sein de la nouvelle structure assemblée un état de contraintes prédéterminé dans des conditions données par rapport aux conditions d'assemblage.

31. Procédé de réalisation d'une structure complexe selon que l'une quelconque des revendications 1 à 30, **caractérisé en ce que** le procédé inclut, en outre, une étape d'épitaxie pour réaliser un film épitaxié (23) d'un matériau sur une face externe de la structure complexe, la différence d'état de contraintes tangentielles étant choisie de sorte qu'à la température d'épitaxie, cette face externe présente un paramètre de maille compatible de l'épitaxie du matériau désiré.

32. Procédé de réalisation d'une structure complexe selon la revendication 31, **caractérisé en ce que** la structure sur laquelle doit s'opérer l'épitaxie est un film mince (22) obtenu par amincissement de ladite structure après assemblage.

33. Procédé de réalisation d'une structure complexe selon l'une quelconque des revendications 31 ou 32 **caractérisé en ce que** le procédé comprend, en outre, les étapes suivantes :
- assemblage de la structure complexe comprenant le film épitaxié (23) sur une autre structure (25) par deux faces respectives de liaison en créant avant assemblage une différence d'état de contraintes tangentielles entre ces deux nouvelles faces à assembler,
- amincissement de la structure complexe pour libérer une face du film mince épitaxié (23),
- épitaxie d'un nouveau matériau (26) à partir de la face du film mince libérée,
la différence d'état de contraintes tangentielles entre les deux nouvelles faces à assembler étant choisie de sorte que le paramètre de maille du film mince épitaxié (23) soit compatible avec l'épitaxie du nouveau matériau à épitaxier (26).

34. Procédé selon l'une quelconque des revendications 1 à 33, **caractérisé en ce qu'**il est mis en oeuvre sous une atmosphère contrôlée.

35. Procédé selon l'une quelconque des revendications 1 à 33, **caractérisé en ce qu'**il est mis en oeuvre sous hydrogène.

## Claims

1. Method of producing a complex structure wherein respective connecting faces of two basic structures (1, 3; 1, 3, 19; 20, 21, 23, 25) are brought into contact and assembled, **characterized in that**, before bringing them into contact, a tangential stress state difference imposed by curving each of the two basic structures to be assembled is created between the two faces to be assembled by applying mechanical forces to each of the two structures, this difference being selected to obtain within the assembled structure a predetermined stress state under given conditions relative to the assembly conditions.

2. Method according to claim 1 of producing a complex structure, **characterized in that** one of the structures is deformed before offering up the second structure facing it.

3. Method according to either claim 1 or claim 2 of producing a complex structure, **characterized in that** the stress state differences is generated by means of stresses generated independently in each basic structure.

4. Method according to any one of claims 1 to 3 of producing a complex structure, **characterized in that** the two structures are curved so that the two faces to be assembled are respectively concave and convex.

5. Method according to claim 4 of producing a complex structure, **characterized in that** the two structures are curved so that the two faces to be assembled are complementary.

6. Method according to claim 5 of producing a complex structure, **characterized in that** the two structures are curved so that the two faces to be assembled are respectively spherical concave and spherical convex.

7. Method according to any one of claims 1 to 6 of producing a complex structure, **characterized in that** the mechanical forces applied to the basic structure result from the creation of a pressure difference between the two faces of said structure.

8. Method according to claim 7 of producing a complex structure, **characterized in that** the pressure difference between the two faces of the structure to be curved so that it has a concave face to be assembled is created by aspirating said structure onto a concave preform having a suitable profile selected as a function of that to be imparted to the face to be assembled and on which the structure rests locally at its periphery.

9. Method according to claim 7 of producing a complex structure, **characterized in that** the pressure difference between the two faces of the structure to be curved so that it has a concave face to be assembled is created by aspirating said structure into a cavity, the structure resting locally at its periphery on a seal bordering the cavity.

10. Method according to claim 6 of producing a complex structure, **characterized in that** the mechanical forces applied are the result of deforming the structure between complementary first and second preforms, one of which is concave and the other of which is convex, with profiles selected as a function of that to be imparted to the face to be assembled.

11. Method according to claim 10 of producing a complex structure, **characterized in that** the first preform is one of the concave structures to be assembled that has already been curved to the selected profile.

12. Method according to claim 10 or claim 11 of producing a complex structure, **characterized in that** the second preform has aspiration channels for keeping the structure curved, once the first preform has been removed.

13. Method according to any one of claims 1 to 6 of producing a complex structure, **characterized in that** the mechanical forces are applied simultaneously to the two structures to be assembled by deforming the two structures between two preforms having profiles selected as a function of those to be imparted to the faces to be assembled.

14. Method according to any one of claims 1 to 13 of producing a complex structure, **characterized in that** mechanical forces are applied to at least one of the substrates by means of a preform consisting of a mold.

15. Method according to claim 14 of producing a complex structure, **characterized in that** said preform consists of a porous mold.

16. Method according to any one of claims 1 to 13 of producing a complex structure, **characterized in that** mechanical forces are applied to the substrates with the aid of at least one deformable preform.

17. Method according to any one of claims 1 to 13 of producing a complex structure, **characterized in that** the two structures are assembled by molecular bonding.

18. Method according to claim 14 of producing a complex structure, **characterized in that** the two faces to be assembled are treated to facilitate bonding.

19. Method according to any one of claims 1 to 18 of producing a complex structure, **characterized in that** the substrates are assembled by direct contact, the surface of at least one of these substrates being adapted to prevent air from being trapped between the assembled surfaces.

20. Method according to claim 19 of producing a complex structure, **characterized in that** at least one of the substrates is pierced.

21. Method according to claim 20 of producing a complex structure, **characterized in that** said substrate is pierced at its center.

22. Method according to claim 21 of producing a complex structure, **characterized in that** at least one of the substrates includes at least one dead-end channel discharging at the edge of the substrate.

23. Method according to any one of claims 1 to 16 of producing a complex structure, **characterized in that** the substrates are assembled by means of a flow layer.

24. Method according to any one of claims 1 to 23 of producing a complex structure, **characterized in that** assembly is carried out at a temperature higher than room temperature.

25. Method according to claim 24 of producing a complex structure, **characterized in that** the substrates are heated by contact with heated preforms.

26. Method according to claim 25 of producing a complex structure, **characterized in that** the preforms are heated to respective different temperatures.

27. Method according to any one of claims 1 to 26 of producing a complex structure, **characterized in that** the method further includes a technology step including a change of temperature, the tangential stress state difference between the two faces to be assembled being selected so that, during this step, the stresses within the assembled structure remain below a predetermined stress threshold.

28. Method according to claim 27 of producing a complex structure, **characterized in that** the technology step is a heat treatment step.

29. Method according to any one of claims 1 to 28 of producing a complex structure, **characterized in that** the method further includes, after assembling the two basic structures, a step of thinning one of these two structures to produce a thin film, the tangential stress state difference between the two faces to be assembled being selected to impose a given stress level within the resulting thin film.

30. Method according to claim 29 of producing a complex structure, **characterized in that** the thin film is assembled to another basic structure by creating, prior to assembly, a tangential stress state difference between the two faces to be assembled, that difference being selected to obtain within the new assembled structure a predetermined stress state under given conditions relative to the assembly conditions.

31. Method according to any one of claims 1 to 30 of producing a complex structure, **characterized in that** the method further includes an epitaxy step for producing an epitaxially grown film (23) of a material on an external face of the complex structure, the tangential stress state difference being selected so that, at the epitaxy temperature, that external face has a lattice parameter compatible with epitaxial growth of the required material.

32. Method according to claim 31 of producing a complex structure, **characterized in that** the structure on which epitaxy is to be effected is a thin film (22) obtained by thinning said structure after assembly.

33. Method according to either claim 31 or claim 32 of producing a complex structure, **characterized in that** the method further includes the following steps:
- assembling the complex structure including the epitaxially grown film (23) onto another structure (25) via respective connecting faces by creating, a tangential stress state difference between these two new faces to be assembled prior to assembly,
- thinning the complex structure to expose a face of the epitaxially grown thin film (23), and
- epitaxially growing a new material (26) on the exposed face of the thin film,
the tangential stress state difference between the two new faces to be assembled being selected so that the lattice parameter of the epitaxially grown thin film (23) is compatible with epitaxial growth of the new material (26) to be grown epitaxially.

34. Method according to any one of claims 1 to 33, **characterized in that** it is carried out in a controlled atmosphere.

35. Method according to any one of claims 1 to 33, **characterized in that** it is carried out in a hydrogen atmosphere.

## Patentansprüche

1. Verfahren zur Herstellung einer komplexen Struktur, gemäß welchem man zwei Einzelstrukturen (1, 3; 1, 3, 19; 20, 21, 23, 25) mit zwei jeweiligen Verbindungsseiten in Kontakt bringt und zusammenfügt, **dadurch gekennzeichnet, dass** man vor dem In-Kontakt-Bringen eine Differenz des Zustands von tangentialen Spannungen zwischen den beiden zusammenzufügenden Seiten erzeugt, die auferlegt wird, indem jede der beiden zusammenzufügenden Einzelstrukturen durch Anlegen von mechanischen Kräften an jede der beiden Strukturen gekrümmt wird, wobei diese Differenz so gewählt wird, dass man im Inneren der zusammengefügten Struktur einen vorbestimmten Spannungszustand unter gegebenen Bedingungen bezüglich der Zusammenfügungsbedingungen erhält.

2. Verfahren zur Herstellung einer komplexen Struktur nach Anspruch 1, **dadurch gekennzeichnet, dass** man eine der Strukturen verformt, bevor die zweite vor sie gebracht wird.

3. Verfahren zur Herstellung einer komplexen Struktur nach Anspruch 1 oder Anspruch 2, **dadurch gekennzeichnet, dass** die Differenz des Zustands von Spannungen mit Hilfe von Spannungen erzeugt wird, die unabhängig in jeder Einzelstruktur erzeugt werden.

4. Verfahren zur Herstellung einer komplexen Struktur nach einem der Ansprüche 1 bis 3, **dadurch gekennzeichnet, dass** die beiden Strukturen so gekrümmt werden, dass die beiden zusammenzufügenden Seiten konkav bzw. konvex sind.

5. Verfahren zur Herstellung einer komplexen Struktur nach Anspruch 4, **dadurch gekennzeichnet, dass** die beiden Strukturen so gekrümmt werden, dass die beiden zusammenzufügenden Seiten komplementär sind.

6. Verfahren zur Herstellung einer komplexen Struktur nach Anspruch 5, **dadurch gekennzeichnet, dass** die beiden Strukturen so gekrümmt werden, dass die beiden zusammenzufügenden Seiten sphärisch konkav bzw. sphärisch konvex sind.

7. Verfahren zur Herstellung einer komplexen Struktur nach einem der Ansprüche 1 bis 6, **dadurch gekennzeichnet, dass** die an die Einzelstruktur angelegten mechanischen Kräfte sich aus der Erzeugung einer Druckdifferenz zwischen den beiden Seiten dieser Struktur ergeben.

8. Verfahren zur Herstellung einer komplexen Struktur nach Anspruch 7, **dadurch gekennzeichnet, dass** die Druckdifferenz zwischen den beiden Seiten der Struktur, die zu krümmen ist, damit sie eine konkave zusammenzufügende Seite aufweist, durch Ansaugen der Struktur an eine konkave Vorform erzeugt wird, die ein angepasstes Profil aufweist, das in Abhängigkeit von demjenigen gewählt ist, das der zusammenzufügenden Seite zu verleihen ist, und auf der die Struktur an ihrem Umfang örtlich aufliegt.

9. Verfahren zur Herstellung einer komplexen Struktur nach Anspruch 7, **dadurch gekennzeichnet, dass** die Druckdifferenz zwischen den beiden Seiten der Struktur, die zu krümmen ist, damit sie eine konkave zusammenzufügende Seite aufweist, durch Ansaugen der Struktur in das Innere eines Hohlraums erzeugt wird, wobei die Struktur örtlich an ihrem Umfang auf einer den Hohlraum säumenden Dichtung aufliegt.

10. Verfahren zur Herstellung einer komplexen Struktur nach Anspruch 6, **dadurch gekennzeichnet, dass** die angelegten mechanischen Kräfte sich aus der Verformung der Struktur zwischen einer ersten und einer zweiten komplementären Vorform ergeben, deren eine konkav und deren andere konvex ist, mit Profilen, die in Abhängigkeit von demjenigen gewählt sind, das der zusammenzufügenden Seite zu verleihen ist.

11. Verfahren zur Herstellung einer komplexen Struktur nach Anspruch 10, **dadurch gekennzeichnet, dass** die erste Vorform eine der zusammenzufügenden konkaven Strukturen ist, die bereits nach dem gewählten Profil gekrümmt ist.

12. Verfahren zur Herstellung einer komplexen Struktur nach Anspruch 10 oder Anspruch 11, **dadurch gekennzeichnet, dass** die zweite Vorform mit Saugkanälen versehen ist, um die Struktur nach Entfernung der ersten Vorform gekrümmt zu halten.

13. Verfahren zur Herstellung einer komplexen Struktur nach einem der Ansprüche 1 bis 6, **dadurch gekennzeichnet, dass** die mechanischen Kräfte gleichzeitig auf die beiden zusammenzufügenden Strukturen durch Verformung der beiden Strukturen zwischen zwei Vorformen angelegt werden, deren Profile in Abhängigkeit von denjenigen, die den zusammenzufügenden Seiten zu verleihen sind, gewählt sind.

14. Verfahren zur Herstellung einer komplexen Struktur nach einem der Ansprüche 1 bis 13, **dadurch gekennzeichnet, dass** das Anlegen von mechanischen Kräften an mindestens eines der Substrate mit Hilfe einer aus einer Form bestehenden Vorform vorgenommen wird.

15. Verfahren zur Herstellung einer komplexen Struktur nach Anspruch 14, **dadurch gekennzeichnet, dass** diese Vorform aus einer porösen Form besteht.

16. Verfahren zur Herstellung einer komplexen Struktur nach einem der Ansprüche 1 bis 13, **dadurch gekennzeichnet, dass** das Anlegen von mechanischen Kräften auf die Substrate mit Hilfe mindestens einer verformbaren Vorform vorgenommen wird.

17. Verfahren zur Herstellung einer komplexen Struktur nach einem der Ansprüche 1 bis 13, **dadurch gekennzeichnet, dass** die Zusammenfügung zwischen den beiden Strukturen eine molekulare Verklebung ist.

18. Verfahren zur Herstellung einer komplexen Struktur nach Anspruch 14, **dadurch gekennzeichnet, dass** die beiden zusammenzufügenden Seiten behandelt werden, um die Verklebung zu erleichtern.

19. Verfahren zur Herstellung einer komplexen Struktur nach einem der Ansprüche 1 bis 18, **dadurch gekennzeichnet, dass** die Zusammenfügung zwischen den Substraten durch direkten Kontakt vorgenommen wird, wobei die Oberfläche mindestens eines der Substrate so ausgebildet ist, dass ein Lufteinschluss zwischen den zusammengefügten Seiten vermieden wird.

20. Verfahren zur Herstellung einer komplexen Struktur nach Anspruch 19, **dadurch gekennzeichnet, dass** mindestens eines der Substrate durchbohrt ist.

21. Verfahren zur Herstellung einer komplexen Struktur nach Anspruch 20, **dadurch gekennzeichnet, dass** dieses Substrat in seiner Mitte durchbohrt ist.

22. Verfahren zur Herstellung einer komplexen Struktur nach Anspruch 21, **dadurch gekennzeichnet, dass** mindestens eines der Substrate mindestens einen nicht durchgehenden Kanal umfasst, der am Rand des Substrats ausmündet.

23. Verfahren zur Herstellung einer komplexen Struktur nach einem der Ansprüche 1 bis 16, **dadurch gekennzeichnet, dass** die Zusammenfügung zwischen den Substraten mit Hilfe einer Kriechschicht vorgenommen wird.

24. Verfahren zur Herstellung einer komplexen Struktur nach einem der Ansprüche 1 bis 23, **dadurch gekennzeichnet, dass** man die Zusammenfügung bei einer Temperatur über der Umgebungstemperatur vornimmt.

25. Verfahren zur Herstellung einer komplexen Struktur nach Anspruch 24, **dadurch gekennzeichnet, dass** die Substrate durch Kontakt mit erhitzten Vorformen erhitzt werden.

26. Verfahren zur Herstellung einer komplexen Struktur nach Anspruch 25, **dadurch gekennzeichnet, dass** die Vorformen auf unterschiedliche Temperaturen erhitzt werden.

27. Verfahren zur Herstellung einer komplexen Struktur nach einem der Ansprüche 1 bis 26, **dadurch gekennzeichnet, dass** das Verfahren außerdem einen technologischen Schritt einschließt, der eine Temperaturänderung umfasst, wobei die Differenz des Zustands von tangentialen Spannungen zwischen den beiden zusammenzufügenden Seiten so gewählt ist, dass die Spannungen im Inneren der zusammengefügten Struktur bei diesem Schritt unter einer vorbestimmten Spannungsschwelle bleiben.

28. Verfahren zur Herstellung einer komplexen Struktur nach Anspruch 27, **dadurch gekennzeichnet, dass** der technologische Schritt ein Wärmebehandlungsschritt ist.

29. Verfahren zur Herstellung einer komplexen Struktur nach einem der Ansprüche 1 bis 28, **dadurch gekennzeichnet, dass** das Verfahren außerdem nach dem Zusammenfügen der beiden Einzelstrukturen einen Schritt der Verdünnung einer dieser beiden Strukturen zu einer Dünnschicht einschließt, wobei die Differenz des Zustands von tangentialen Spannungen zwischen den beiden zusammenzufügenden Seiten so gewählt wird, dass im Inneren der gebildeten Dünnschicht ein gegebenes Spannungsniveau auferlegt wird.

30. Verfahren zur Herstellung einer komplexen Struktur nach Anspruch 29, **dadurch gekennzeichnet, dass** man die Dünnschicht mit einer anderen Einzelstruktur zusammenfügt, indem man vor dem Zusammenfügen eine Differenz des Zustands von tangentialen Spannungen zwischen den beiden zusammenzufügenden Seiten erzeugt, wobei diese Differenz so gewählt wird, dass man im Inneren der neuen zusammengefügten Struktur einen vorbestimmten Spannungszustand unter gegebenen Bedingungen bezüglich der Zusammenfügungsbedingungen erhält.

31. Verfahren zur Herstellung einer komplexen Struktur nach einem der Ansprüche 1 bis 30, **dadurch gekennzeichnet, dass** das Verfahren außerdem einen Schritt der Epitaxie einschließt, um eine Schicht (23) eines Werkstoffs, die auf eine Außenseite der komplexen Struktur epitaxiert ist, herzustellen, wobei die Differenz des Zustands von tangentialen Spannungen so gewählt ist, dass diese Außenseite bei der Epitaxietemperatur einen mit der Epitaxie des gewünschten Werkstoffs kompatiblen Gitterparameter aufweist.

32. Verfahren zur Herstellung einer komplexen Struktur nach Anspruch 31, **dadurch gekennzeichnet, dass** die Struktur, auf der die Epitaxie stattfinden soll, eine Dünnschicht (22) ist, die durch Verdünnung dieser Struktur nach Zusammenfügung erhalten wird.

33. Verfahren zur Herstellung einer komplexen Struktur nach einem der Ansprüche 31 oder 32, **dadurch gekennzeichnet, dass** das Verfahren außerdem die folgenden Schritte umfasst:
- Zusammenfügen der komplexen Struktur, die die auf eine andere Struktur (25) epitaxierte Schicht (23) umfasst, mit zwei Verbindungsseiten, indem vor dem Zusammenfügen eine Differenz des Zustands von tangentialen Spannungen zwischen diesen beiden neuen zusammenzufügenden Seiten erzeugt wird,
- Verdünnen der komplexen Struktur, um eine Seite der epitaxierten Dünnschicht (23) freizulegen,
- Epitaxie eines neuen Werkstoffs (26) von der freigesetzten Seite der Dünnschicht aus,
wobei die Differenz des Zustands von tangentialen Belastungen zwischen den beiden neuen zusammenzufügenden Seiten so gewählt ist, dass der Gitterparameter der epitaxierten Dünnschicht (23) mit der Epitaxie des neuen zu epitaxierenden Werkstoffs (26) kompatibel ist.

34. Verfahren nach einem der Ansprüche 1 bis 33, **dadurch gekennzeichnet, dass** es unter einer gesteuerten Atmosphäre durchgeführt wird.

35. Verfahren nach einem der Ansprüche 1 bis 33, **dadurch gekennzeichnet, dass** es unter Wasserstoff durchgeführt wird.
